# EUROPÄISCHE PATENTSCHRIFT

(11) **EP 2 593 819 B1**
(45) Veröffentlichungstag und Bekanntmachung des Hinweises auf die Patenterteilung: **12.11.2014**
(21) Anmeldenummer: 11748561.5
(22) Anmeldetag: 11.07.2011
(51) Int. Cl.: G02B 5/20, G02B 1/00, G02B 5/00

(54) **OPTISCHES BANDPASS-FILTERSYSTEM, INSBESONDERE FÜR MEHRKANALIGE SPEKTRALSELEKTIVE MESSUNGEN**
OPTICAL BANDPASS FILTER SYSTEM, IN PARTICULAR FOR MULTICHANNEL SPECTRAL-SELECTIVE MEASUREMENTS
SYSTÈME DE FILTRE PASSE-BANDE OPTIQUE, DESTINÉ NOTAMMENT À DES MESURES SPECTRALEMENT SÉLECTIVES SUR PLUSIEURS CANAUX

(30) Priorität: 15.07.2010 DE 102010027252
(43) Veröffentlichungstag der Anmeldung: 22.05.2013
(73) Patentinhaber: Fraunhofer-Gesellschaft zur Förderung der angewandten Forschung e.V., 80686 München (DE)
(72) Erfinder: JUNGER, Stephan, 91088 Bubenreuth (DE); TSCHEKALINSKIJ, Wladimir, 90429 Nürnberg (DE); WEBER, Norbert, 91367 Weissenohe (DE)
(74) Vertreter: Gagel, Roland
(86) Internationale Anmeldenummer: PCT/EP2011/003468
(87) Internationale Veröffentlichungsnummer: WO 2012/007147

(56) Entgegenhaltungen:
- EP-A2- 1 098 210
- WO-A1-2009/011439
- WO-A2-02/18985
- US-A1- 2002 009 251
- PETER A.R. ADE, ET AL.: "A review of metal mesh filters", SPIE, PO BOX 10 BELLINGHAM WA 98227-0010 USA, Bd. 6275, 2006, Seiten 62750U-1-62750U-15, XP040227409,
- EBBESEN T W ET AL: "Extraordinary optical transmission through sub-wavelength hole arrays", NATURE, NATURE PUBLISHING GROUP, LONDON, GB, Bd. 391, Nr. 6668, 12. Februar 1998 (1998-02-12), Seiten 667-669, XP002133009, ISSN: 0028-0836, DOI: 10.1038/35570 in der Anmeldung erwähnt

## Beschreibung

### Technisches Anwendungsgebiet

Die vorliegende Erfindung betrifft ein optisches Bandpass-Filtersystem, das mindestens einen Bandpassfilter mit einer spektralselektiven Durchlässigkeit aufweist.

Optische Filtersysteme werden vor allem im Bereich der optischen Sensorik benötigt, bspw. für spektroskopische Messaufgaben oder für die spektralselektive optische Detektion. Die zunehmende Miniaturisierung optischer Sensoren erfordert Filtersysteme mit geringen lateralen Abmessungen, bspw. für optische Bildsensoren oder Chipsize-Spektrometer. Für die Erfassung von mehr als drei Farbkanälen oder für schmalbandige spektroskopische Messungen ist gleichzeitig eine geringe spektrale Bandbreite der eingesetzten Filtersysteme erforderlich. In Verbindung mit CMOS-Bauelementen sind außerdem Filtersysteme wünschenswert, die sich in einfacher Weise in den CMOS-Prozess integrieren lassen.

### Stand der Technik

Konventionelle optische Bandpassfilter mit geringer spektraler Bandbreite werden durch dielektrische Dünnschichtfiltersysteme als Interferenzfilter realisiert. Diese bestehen aus typischerweise mehr als 50 Schichten, die beispielsweise durch Aufdampfen nacheinander aufgebracht werden. Eine Variation der Filterwellenlänge ist nur durch Variation der Schichtdicken möglich, wodurch eine lateral benachbarte Anordnung verschiedener Filter auf kleinstem Raum nur sehr aufwendig zu realisieren ist.

Weiterhin sind optische Bandpassfilter bekannt, die mit Hilfe von optischen Nanostrukturen, insbesondere Arrays aus Subwellenlängen-Öffnungen, in der vorliegenden Patentanmeldung auch als Locharray bezeichnet, in dünnen Metallschichten realisiert werden. Grundlage für diese sog. EOT-Filter (EOT: Extraordinary Optical Transmission) ist die Veröffentlichung von T. W. Ebbesen et al., "Extraordinary optical transmission through subwavelength hole arrays", Nature 391, 667 (1998). Die Dokumente WO 2009/011439 und "A review of Metal Mesh Filters", von Peter A.R. Ade et al, Millimeter and Submillimeter Detectors and Instrumentation for Astronomy III, Proc. of SPIE Vol. 6275, pg. 62750U-1, 2006 offenbaren solche Filter. Eine benachbarte Anordnung verschiedener Filter ist hier sehr einfach möglich, da eine Variation der Filterwellenlänge alleine über die laterale Ausgestaltung der Nanostrukturen in der Metallschicht, insbesondere über den Durchmesser und den Abstand der Öffnungen, bei ansonsten konstanter Schichtdicke erreicht wird. Eine derartige Filteranordnung ist für die Fertigung im Rahmen von Halbleiterprozessen, bspw. eines CMOS-Prozesses, von Vorteil, da dort Schichten mit konstanter Dicke verwendet werden müssen. Auf diese Weise können bspw. die Photodioden eines Photodiodenarrays mit unterschiedlichen Filtern versehen werden, ohne dass eine Nachprozessierung, insbesondere ein späteres Aufbringen und Strukturieren einer zusätzlichen Schicht erforderlich ist. Durch die Kombination eines Photodiodenarrays mit einem Filterarray aus lateral unterschiedlich ausgebildeten optischen Nanostrukturen in einer metallischen Schicht konstanter Schichtdicke können verschiedene spektrale Kanäle auf einem Chip kombiniert werden, sowohl für einzelne Farbsensoren als auch für die Pixel eines Bildsensors.

Optische Bandpassfilter aus metallischen Nanostrukturen weisen allerdings eine vergleichsweise große spektrale Bandbreite von typischerweise 100 nm auf. Die damit verbundene Filterwirkung ist zur einfachen Farbanalyse mit bspw. drei Farbkanälen verwendbar, für genauere spektrale oder quasi-spektrale Messungen mit mehr als drei Kanälen sowie für spektroskopische Messaufgaben aber nicht ausreichend. Multispektrale Sensoren mit deutlich mehr als drei Kanälen und Chipsize-Spektrometer können mit derartigen Filtern also bisher nicht realisiert werden. Auch sensorische Messaufgaben, bei denen wenige (ein bis drei) Kanäle zwar ausreichen, diese aber schmalbandig erfasst werden müssen, können mit diesen Filtern bisher nicht umgesetzt werden. Schmalbandigere Bandpassfilter aus metallischen Nanostrukturen sind bisher nicht bekannt.

Die Aufgabe der vorliegenden Erfindung besteht darin, ein optisches Bandpass-Filtersystem anzugeben, das eine lateral benachbarte Anordnung verschiedener Filter mit geringer spektraler Bandbreite auf kleinstem Raum ermöglicht und dessen Herstellung sich in einen Halbleiterprozess, insbesondere einen CMOS-Prozess, in einfacher Weise integrieren lässt.

### Darstellung der Erfindung

Die Aufgabe wird mit dem optischen Filtersystem gemäß Patentanspruch 1 gelöst. Vorteilhafte Ausgestaltungen des optischen Filtersystems sind Gegenstand der abhängigen Patentansprüche oder lassen sich der nachfolgenden Beschreibung sowie den Ausführungsbeispielen entnehmen.

Das vorgeschlagene optische Filtersystem weist zumindest eine Kombination aus einem Bandpassfilter und einem Tiefpassfilter, im folgenden Bandstoppfilter genannt, auf, die zur Erzielung einer kombinatorischen Filterwirkung übereinander angeordnet sind. Der Bandpassfilter ist aus einer ersten nanostrukturierten metallischen Schicht einer ersten Schichtdicke und der Bandstoppfilter aus einer zweiten nanostrukturierten metallischen Schicht einer zweiten Schichtdicke gebildet, wobei die erste Schichtdicke anders als die zweite Schichtdicke gewählt ist. Der Bandstoppfilter ist dabei so auf den Bandpassfilter abgestimmt, dass er einen zusammenhängenden Wellenlängenbereich blockiert, der sich mit einer Durchlassbandbreite des Bandpassfilters teilweise überschneidet. Damit wird eine der Flanken des Durchlassbereiches des Bandpassfilters durch den Bandstoppfilter abgeschnitten, so dass das optische Filtersystem eine geringere Durchlassbandbreite bzw. spektrale Bandbreite aufweist als der Bandpassfilter. Die unterschiedliche Wahl der Schichtdicken ermöglicht eine verbesserte Filtercharakteristik mit einer hohen Filtertransmission bei der Mittenwellenlänge des Filtersystems.

Vorzugsweise wird die erste Schichtdicke im Bereich zwischen 130 nm und 270 nm, besonders bevorzugt zwischen 150 nm und 250 nm, und die zweite Schichtdicke im Bereich zwischen 30 nm und 170 nm, besonders bevorzugt zwischen 50 nm und 150 nm, gewählt. Mit diesen Werten werden besonders vorteilhafte Filtercharakteristiken erreicht, insbesondere hinsichtlich der Kombination aus schmaler Bandbreite mit steilen Flanken und hoher Transmission bei der Mittenwellenlänge.

Vorzugsweise wird der Bandpassfilter dabei durch eine als Locharray nanostrukturierte metallische Schicht realisiert, d. h. in Form eines EOT-Filters. Die relativ breite Durchlassbandbreite dieses Filters wird dabei durch die Kombination mit dem Bandstoppfilter im Gesamtsystem deutlich reduziert. Ein derartiger Bandpassfilter besteht aus einem Array aus Nanoaperturen in einer dünnen Metallschicht, wie dies aus dem Stand der Technik bekannt ist. Die Nanoaperturen können dabei kreisrund sein oder auch andere geometrische Formen aufweisen. Die Mittenwellenlänge des Durchlassbereiches (bezogen auf die Halbwertsbreite des Durchlassbereiches), im Folgenden auch als Filterwellenlänge bezeichnet, wird vor allem durch die Periode bzw. den Abstand der Aperturen sowie in geringerem Ausmaß durch den Durchmesser der Aperturen bestimmt. Der Aperturdurchmesser beeinflusst vor allem die Filterbandbreite, so dass durch eine geeignete Wahl dieser beiden Parameter Filterwellenlänge und -bandbreite in gewissen Grenzen eingestellt werden können. Ein besonderer Vorteil eines derartigen Filters auf Basis einer nanostrukturierten metallischen Schicht besteht darin, dass auf einfache Weise und kleinstem Raum Filter mit unterschiedlicher Filtercharakteristik, insbesondere unterschiedlichen Filterwellenlängen, nebeneinander auf einem Substrat erzeugt werden können. Hierbei ist nur eine metallische Schicht einer einheitlichen Dicke erforderlich, die entsprechend nanostrukturiert wird. Der Nachteil der relativ großen Bandbreite eines derartigen Filters wird durch die Kombination mit dem Bandstoppfilter bei dem vorliegenden optischen Filtersystem vermieden.

Ein derartig ausgebildeter Bandpassfilter wird vorzugsweise mit einem Bandstoppfilter kombiniert, der ebenfalls aus einer metallischen Schicht einheitlicher bzw. konstanter Dicke gebildet ist, die zur Bildung einer zu Locharrays komplementären Struktur, insbesondere einer periodischen Anordnung von metallischen Quadern oder Zylindern, nanostrukturiert ist, in der vorliegenden Patentanmeldung auch als Inselarray bezeichnet. Eine derartige Struktur weist die Charakteristik eines Bandstoppfilters auf, dessen Sperrbereich (Lage und Breite) durch die Wahl der Periode bzw. des Abstands und der Größe der Quader oder Zylinder eingestellt werden kann. Eine derartige Kombination aus Bandpassfilter und Bandstoppfilter lässt sich sehr vorteilhaft mit Prozessen der Halbleitertechnologie, insbesondere in einem CMOS-Prozess, realisieren, da beide Filter jeweils lediglich eine metallische Schicht einheitlicher Dicke erfordern, die entsprechend der gewünschten Filtercharakteristik strukturiert wird. Auch beim Bandstoppfilter können dabei durch unterschiedliche Strukturierung unterschiedliche Filtercharakteristiken nebeneinander auf kleinstem Raum generiert werden. Vorteilhafterweise sind die beiden Filter hierbei durch eine CMOSkompatible Schicht aus einem für die gewünschte Durchlassbandbreite transparenten Material getrennt, bspw. aus SiO₂. Die metallischen Schichten werden dabei selbstverständlich ebenfalls CMOS-kompatibel gewählt, d.h. bspw. aus Aluminium.

Wesentlich bei dem vorgeschlagenen Filtersystem ist, dass der Bandstoppfilter den Durchlassbereich des Bandpassfilters von einer Wellenlängenseite her, d. h. von der kurzwelligen Seite oder der langwelligen Seite im Gesamtsystem einschränkt. Dadurch wird eine geringere Durchlassbandbreite des Filtersystems erreicht. Da sich alle Filter in Form einer strukturierten Schicht konstanter Dicke (im Zustand vor der Strukturierung) realisieren lassen, kann das vorgeschlagene Filtersystem auf einfache Weise in einen Halbleiterprozess zur Herstellung optischer Sensoren integriert werden. Die durch die Kombinationswirkung der beiden Filter erreichbare schmale Durchlassbandbreite und die im Herstellungsprozess einfache Variationsmöglichkeit der Filterwellenlänge ermöglicht eine laterale Anordnung von Filtern bzw. Filterkombinationen mit unterschiedlicher schmaler Durchlasscharakteristik auf kleinstem Raum.

In einer bevorzugten Ausgestaltung des vorgeschlagenen Filtersystems sind daher auch mehrere der Kombinationen aus Bandpassfilter und Bandstoppfilter nebeneinander auf einem Substrat oder Träger angeordnet, wobei zumindest einige der Kombinationen unterschiedliche Wellenlängen-Durchlassbereiche, insbesondere gegeneinander verschobene Mittenwellenlängen aufweisen. Damit lassen sich optische Sensoren mit mehreren schmalbandigen Farbkanälen auf kleinstem Raum realisieren.

Schmalbandige optische Bandpassfiltersysteme spielen in der Sensorik und der Spektroskopie eine große Rolle. Eine Anordnung von bspw. 10 oder mehr derartiger Filtersysteme auf einem Array von CMOS-Photodioden ermöglicht die Realisierung eines Chipsize-Spektrometers. Wird das vorgeschlagene Filtersystem für Bildsensoren eingesetzt, so sind Multispektralkameras, bspw. für 16 Wellenlängen, ohne mechanisch bewegte Teile wie Filterräder realisierbar. Auch im Falle der Verwendung von wenigen Kanälen erfordert die Anwendung, bspw. in der Analytik, oft schmalbandige optische Bandpassfilter, wie sie mit dem vorgeschlagenen Filtersystem bereitgestellt werden. Das optische Filtersystem lässt sich dabei bspw. für Anwendungen im Bereich der Überwachung und Regelung von LED's für viele Beleuchtungssituationen, z. B. für Gebäude und LCD-Backlights, für die Überwachung und Regelung der Druckfarben im Druckprozess, für miniaturisierte Multispektralsensoren/Minispektrometer für die Analytik von Gasen, Flüssigkeiten oder Gewebe sowie bei Multispektralkameras zur ortsaufgelösten spektralen Erfassung einsetzen.

Die geeignete Dimensionierung der in dem vorgeschlagenen Filtersystem eingesetzten Filter aus nanostrukturierten metallischen Schichten lässt sich bspw. durch kommerziell erhältliche Software wie OptiFDTD der Optiwave Corporation oder durch frei verfügbare Software, wie sie aus A. F. Oskooi et al., "MEEP: A flexible free-software package for electromagnetic simulations by the FDTD method", Computer Physics Communications 181, 687 - 702 (2010) durchführen. Die für die gewünschte Filterwirkung und Bandstoppwirkung erforderlichen Durchmesser und Abstände der Aperturen bzw. erhabenen Bereiche wie Quader oder Zylinder lassen sich mit einem derartigen Programm bestimmen. Die Strukturierung in der metallischen Schicht erfolgt dann in bekannter Weise über Photolithographie mit anschließender Ätztechnik.

### Kurze Beschreibung der Zeichnungen

Das vorgeschlagene optische Filtersystem wird nachfolgend anhand von Ausführungsbeispielen in Verbindung mit den Zeichnungen nochmals kurz erläutert. Hierbei zeigen:
- Fig. 1: ein Beispiel für den Durchlassbereich eines EOT-Bandpassfilters;
- Fig. 2: ein Beispiel für die wellenlängenabhängige Transmission eines optischen Bandstoppfilters auf Basis einer nanostrukturierten Metallschicht;
- Fig. 3: ein Beispiel für den Durchlassbereich des vorgeschlagenen optischen Filtersystems;
- Fig. 4: einen Vergleich des Durchlassbereiches des vorgeschlagenen optischen Filtersystems mit dem Durchlassbereich eines EOT-Bandpassfilters gemäß Figur 1 und dem Durchlassbereich einer Kombination zweier identischer EOT-Bandpassfilter; und
- Fig. 5: ein Beispiel für den Aufbau des vorgeschlagenen Filtersystems aus einem EOT-Bandpassfilter und einem Bandstoppfilter, jeweils aus einer nanostrukturierten metallischen Schicht.

### Wege zur Ausführung der Erfindung

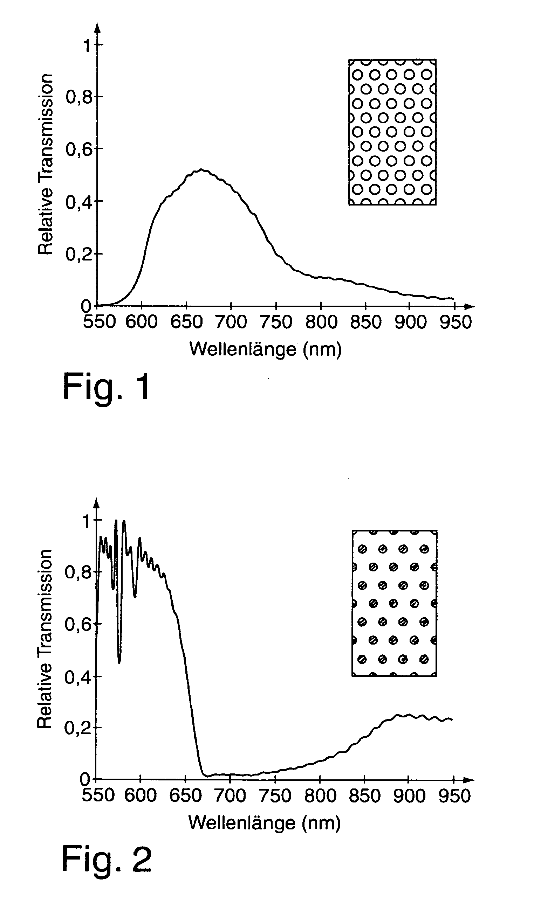

Figur 1 zeigt die Simulation der wellenlängenabhängigen Transmission eines optischen Bandpassfilters, der aus einer metallischen Schicht mit einem Array aus Nanoaperturen (Locharray) gebildet wird. Der Bandpassfilter weist eine Transmission von ca. 50% bei 670 nm und eine Halbwertsbreite (FWHM: full width half maximum) von etwa 113 nm auf. Trotz einer bereits erfolgten Optimierung kann die Filterbandbreite eines derartigen Filters nicht weiter reduziert werden. Der relevante Wellenlängenbereich liegt in diesem Ausführungsbeispiel bei 350 bis 1100 nm, die Dicke der Metallschicht eines derartigen Filters im vorgeschlagenen Filtersystem im Bereich zwischen 130 nm und 270 nm. Typische Lochdurchmesser betragen 100 bis 300 nm, die Periode des Lochgitters 200 bis 600 nm. Die Struktur dieses Filters ist im rechten oberen Teil des Diagramms in Draufsicht schematisch angedeutet.

Figur 2 zeigt die Simulation eines optischen Bandstoppfilters, der durch eine periodische Anordnung von metallischen Zylindern (Inselarray) in einer metallischen Schicht realisiert wurde. Ab einer Wellenlänge von etwa 630 nm zeigt der spektrale Verlauf eine Bandstoppfiltercharakteristik. Auch hier ist im rechten oberen Teil die Struktur dieses Filters in Draufsicht angedeutet. Bei einem derartigen Filter haben die Zylinder typische Durchmesser von 100 bis 300 nm und im vorgeschlagenen Filtersystem eine Höhe von 30 bis 170 nm.

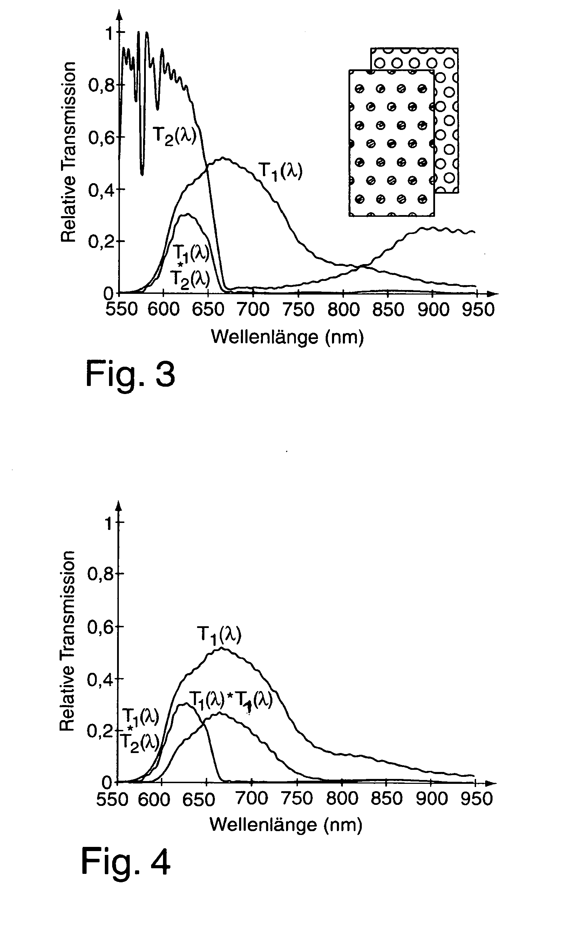

Die Grundidee des hier vorgeschlagenen optischen Filtersystems besteht darin, einen Bandpassfilter mit einer relativ großen spektralen Bandbreite, wie den der Figur 1, durch Kombination mit einem bzgl. der Mittenwellenlänge leicht versetzten Bandstoppfilter, wie dem der Figur 2, in seiner spektralen Bandbreite zu verringern, wobei durch die unterschiedliche Wahl der Schichtdicken der beiden Filterschichten eine hohe Transmission bei der resultierenden Mittenwellenlänge des Filtersystems erreicht werden kann. Die Kombination dieser beiden Filterarten ist in Figur 3 dargestellt. T₁ (λ) zeigt den Transmissionsverlauf des breiten Bandpassfilters der Figur 1. T₂ (λ) zeigt den Transmissionsverlauf des Bandstoppfilters der Figur 2. Die resultierende Produktfunktion T₁ (λ) x T₂ (λ) entspricht dem Transmissionsverlauf bzw. Wellenlängen-Durchlassbereich des vorgeschlagenen Filtersystems.

Sofern der Abstand von Bandpass- und Bandstoppfilter größer als die Ausdehnung der jeweiligen evaneszenten Felder ist, bspw. größer als 200 nm, kommt es nicht zu einer Kopplung der Feldverteilungen beider Filterstrukturen und die resultierenden Filtercharakteristik entspricht in guter Näherung der gezeigten Produktfunktion T₁ (λ) x T₂ (λ). Ein gewisser Abstand der beiden Filterschichten ist technologisch meist ohnehin erforderlich. Auch ein geringerer Abstand mit einer Feldverkopplung beider Nanostrukturen führt allerdings zu einer ähnlichen Filtercharakteristik, deren genaues Verhalten ebenfalls durch Simulation der zweilagigen Anordnung optimiert werden kann. Der oben genannte Abstand ist daher für die Funktion des vorgeschlagenen optischen Filtersystems nicht zwingend erforderlich.

Aus Figur 3 ist ersichtlich, dass das durch Kombination der beiden Filter erhaltene optische Filtersystem eine gegenüber dem Bandpassfilter der Figur 1 deutlich reduzierte Haltwertsbreite aufweist. Figur 4 zeigt hierzu einen Vergleich der wellenlängenabhängigen Transmission T₁ (λ) des Bandpassfilters der Figur 1, der wellenlängenabhängigen Transmission bei Kaskadierung zweier identischer Bandpassfilter T₁ (λ) x T₁ (λ) sowie der wellenlängenabhängigen Transmission des vorgeschlagenen Filtersystems gemäß Figur 3. Die Filterhalbwertsbreite ist mit 47 nm (FWHM) gegenüber dem Bandpassfilter der Figur 1 mit 113 nm erheblich, gegenüber der kaskadierten zweistufigen Bandpassfilteranordnung mit 93 nm um den Faktor 2 reduziert. Auch die maximale Transmission liegt mit 30% etwas höher als im Falle der kaskadierten Anordnung mit 25%.

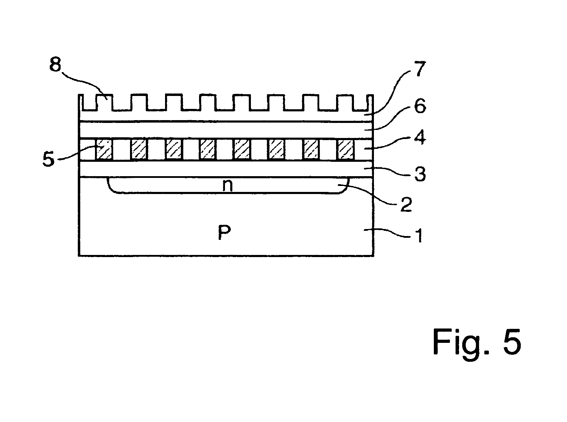

Figur 5 zeigt stark schematisiert ein Beispiel für einen Aufbau des vorgeschlagenen Filtersystems über einer Photodiode. Die Figur zeigt nur einen Ausschnitt einer Anordnung, bei der in einem Substrat mehrere Photodioden nebeneinander ausgebildet sind, auf denen dann das entsprechende optische Filtersystem ausgebildet ist. Das optische Filtersystem weist hierbei mehrere nebeneinander angeordnete Filter bzw. Filterkombinationen auf, wobei je eine Filterkombination über einer Photodiode liegt. Mehrere der Filterkombinationen weisen dabei vorzugsweise unterschiedliche Filtercharakteristiken auf, indem die Filter unterschiedlich strukturiert wurden. Die jeweilige Photodiode wird in diesem Beispiel durch eine n-dotierte Wanne 2 in einem p-dotierten Halbleitersubstrat 1 gebildet. Darüber werden eine dielektrische Zwischenschicht 3 und eine metallische Schicht 4 abgeschieden, in der entsprechend der gewünschten Filtercharakteristik Nanoaperturen 5 erzeugt werden. Über diesem, durch die erste strukturierte metallische Schicht 4 gebildeten Bandpassfilter wird dann eine weitere dielektrische Zwischenschicht 6 abgeschieden, auf die wiederum eine zweite metallische Schicht 7 aufgebracht wird. Die zweite metallische Schicht 7 hat eine geringere Schichtdicke als die den Bandpassfilter bildende erste metallische Schicht 4 und wird zur Bildung des gewünschten Bandstoppfilters strukturiert, wobei zylinder- oder quaderförmige Strukturen 8 in den gewünschten lateralen Dimensionen und Abständen gemäß der beabsichtigten Filtercharakteristik erzeugt werden. Die dielektrische Zwischenschichten 3, 6 können beispielsweise Siliziumdioxid-Schichten (SiO₂) sein. Die elektrischen Kontaktierungen der p- und n-Bereiche der Photodiode sind in der Figur nicht dargestellt. Diese werden in der Regel über geeignete Durchkontaktierungen durch die einzelnen Schichten realisiert. Weiterhin können unterhalb der ersten metallischen Schicht 4, oberhalb der zweiten metallischen Schicht 7 sowie zwischen diesen beiden metallischen Schichten selbstverständlich weitere CMOS-Prozessschichten liegen, die für die jeweilige Funktion des Bauelementes erforderlich sind.

### Bezugszeichenliste

- 1: p-dotiertes Halbleitersubstrat
- 2: n-dotierte Wanne
- 3: dielektrische Zwischenschicht
- 4: erste metallische Schicht für Bandpassfilter
- 5: Nanoaperturen
- 6: dielektrische Zwischenschicht
- 7: zweite metallische Schicht für Bandstoppfilter
- 8: zylinder- oder quaderförmige Nanostrukturen

## Patentansprüche

1. Optisches Filtersystem für den Wellenlängenbereich zwischen 350 und 1100 nm, das zumindest eine Kombination aus einem Bandpassfilter aus einer ersten nanostrukturierten metallischen Schicht (4) einer ersten Schichtdicke und einem Tiefpassfilter aus einer zweiten nanostrukturierten metallischen Schicht (7) einer zweiten Schichtdicke aufweist, die übereinander angeordnet sind, wobei die erste nanostrukturierte metallische Schicht (4) ein Locharray (5) und die zweite nanostrukturierte metallische Schicht (7) ein Inselarray (8) bilden und der Tiefpassfilter so auf den Bandpassfilter abgestimmt ist, dass er einen zusammenhängenden Wellenlängenbereich blockiert, der sich mit einer Durchlass-Bandbreite des Bandpassfilters teilweise überschneidet, und wobei sich die erste und die zweite Schichtdicke unterscheiden, die erste Schichtdicke zwischen 150 nm und 250 nm und die zweite Schichtdicke zwischen 50 nm und 150 nm gewählt ist.

2. Optisches Filtersystem nach Anspruch 1, **dadurch gekennzeichnet,**
**dass** mehrere der Kombinationen aus dem Bandpassfilter und dem Tiefpassfilter nebeneinander angeordnet sind.

3. Optisches Filtersystem nach Anspruch 2,
**dadurch gekennzeichnet,**
**dass** zumindest einige der Kombinationen unterschiedliche Wellenlängen-Durchlassbereiche aufweisen.

4. Optisches Filtersystem nach einem der Ansprüche 1 bis 3, **dadurch gekennzeichnet,**
**dass** die einzelnen Filter laterale Abmessungen von ≤ 5 mm aufweisen.

5. Optischer Sensor oder Spektrometer mit einem Filtersystem nach einem der vorangehenden Patentansprüche zur wellenlängenselektiven Detektion.

## Claims

1. An optical filter system for the wavelength range between 350 and 1100 nm, which has at least a combination of a band-pass filter made up of a first nanostructured metallic layer (4) of a first layer thickness and a low-pass filter made up of a second nanostructured metallic layer (7) of a second layer thickness, which are arranged above one another, wherein the first nanostructured metallic layer (4) forms a hole array (5) and the second nanostructured metallic layer (7) forms an island array (8) and the low-pass filter is tuned to the band-pass filter in such a manner that it blocks a continuous wavelength range, which overlaps with a pass bandwidth of the band-pass filter to some extent, and wherein the first and the second layer thicknesses differ, the first layer thickness is chosen between 150 nm and 250 nm and the second layer thickness is chosen between 50 nm and 150 nm.

2. The optical filter system according to claim 1,
**characterised**
**in that** a plurality of the combinations of the band-pass filter and the low-pass filter are arranged next to one another.

3. The optical filter system according to claim 2,
**characterised**
**in that** at least several of the combinations have different wavelength pass ranges.

4. The optical filter system according to one of claims 1 to 3,
**characterised**
**in that** the individual filters have lateral dimensions of ≤ 5 mm.

5. An optical sensor or spectrometer having a filter system according to one of the preceding patent claims for wavelength-selective detection.

## Revendications

1. Système de filtre optique pour la plage de longueurs d'ondes comprise entre 350 et 1100 nm, lequel présente au moins une combinaison à base d'un filtre passe-bande en une première couche métallique nanostructurée (4) d'une première épaisseur de couche et d'un filtre passe-bas en une deuxième couche métallique nanostructurée (7) d'une deuxième épaisseur de couche, lesquels sont disposés l'un au-dessus de l'autre, la première couche métallique nanostructurée métallique (4) formant un réseau de trous (5) et la deuxième couche métallique nanostructurée (7) formant un réseau d'îlots (8), et le filtre passe-bas étant adapté au filtre passe-bande de manière à ce qu'il bloque une plage de longueurs d'ondes contigües qui chevauche partiellement une largeur de bande passante du filtre passe-bande, et la première et la deuxième épaisseur de couche étant différentes, la première épaisseur de couche étant choisie entre 150 nm et 250 nm et la deuxième épaisseur de couche entre 50 nm et 150 nm.

2. Système de filtre optique selon la revendication 1,
**caractérisé en**
**ce que** plusieurs des combinaisons à base du filtre passe-bande et du filtre passe-bas sont disposées les unes à côté des autres.

3. Système de filtre optique selon la revendication 2,
**caractérisé en**
**ce qu'**au moins certaines des combinaisons présentent des bandes de transmission de longueurs d'ondes différentes.

4. Système de filtre optique selon l'une des revendications 1 à 3,
**caractérisé en**
**ce que** les filtres individuels présentent des dimensions latérales ≤ 5 mm.

5. Capteur optique ou spectromètre avec un système de filtre selon l'une des revendications précédentes pour la détection sélective en longueur d'onde.
